Europäisches Patentamt

European Patent Office

Office européen des brevets

(11) Numéro de publication: **0 548 725 A1**

## DEMANDE DE BREVET EUROPEEN

(21) Numéro de dépôt: **92121237.9**

(22) Date de dépôt: **14.12.92**

(51) Int. Cl.5: **G01R 19/165**

(30) Priorité: **20.12.91 FR 9115904**

(43) Date de publication de la demande:
**30.06.93 Bulletin 93/26**

(84) Etats contractants désignés:
**AT BE CH DE ES FR GB IT LI NL SE**

(71) Demandeur: **ALCATEL CIT**
**12 Rue de la Baume**
**F-75008 Paris(FR)**

(72) Inventeur: **Le Grand, Yves-Marie**
**1, rue Pablo Picasso**
**F-78190 Trappes(FR)**
Inventeur: **Monteagudo, Michel**
**4, rue du Maréchal Foch**
**F-91700 Sainte Geneviève des Bois(FR)**

(74) Mandataire: **Weinmiller, Jürgen et al**
**Lennéstrasse 9 Postfach 24**
**W-8133 Feldafing (DE)**

(54) **Dispositif d'évaluation de la tension fournie par une source de tension.**

(57) Selon l'invention, le dispositif comporte:
- des premiers moyens (R1,C) pour prélever de l'énergie de la source de tension et pour stocker l'énergie prélevée dans des moyens (C) de stockage;
- des seconds moyens (PH1) pour décharger sur commande l'énergie stockée par les moyens (C) de stockage dans des moyens (PH2) de détection d'énergie électrique indiquant la valeur de la tension fournie par la source de tension avec une puissance au moins égale à la puissance minimale requise par les moyens (PH2) de détection d'énergie électrique, cette puissance minimale requise étant supérieure à la puissance de prélèvement de l'énergie de la source de tension par les premiers moyens (R1,C).

Le dispositif est particulièrement adapté à la détection de connexion d'équipements à un bus de transmission.

FIG.2

Le domaine de l'invention est celui des dispositifs destinés à évaluer la tension fournie par une source de tension, cette évaluation consistant à détecter la présence ou l'absence d'une différence de potentiel. La détection d'une différence de potentiel inférieure à une valeur de seuil est ici considérée comme une absence de différence de potentiel.

Plus précisément, la présente invention concerne un dispositif, à faible consommation, de détection de différence de potentiel pouvant être appliqué à la détection de connexion d'équipements aux bornes d'une source de tension.

Selon une application particulière, un tel équipement est un terminal d'usager d'un réseau de télécommunications et la source de tension est générée de façon continue sur une ligne de transmission. Ce type de dispositif a pour fonction de détecter que l'équipement dans lequel il est compris est ou non connecté à cette ligne de transmission, l'équipement prélevant ou non l'énergie nécessaire à son propre fonctionnement sur cette ligne. La détection d'une connexion, c'est à dire d'un branchement de l'équipement à la ligne de transmission, permet par exemple d'initialiser certains paramètres de cet équipement et/ou de le mettre dans un état l'apprêtant à la réception et/ou l'émission de signaux.

De façon connue, les dispositifs de détection de connexion sont notamment utilisés dans les terminaux d'usager adaptés à un réseau de type RNIS (Réseau Numérique à Intégration de Services) et dans les dispositifs d'adaptation à un tel réseau de terminaux d'usager non adaptés.

La détection de connexion à un bus de transmission s'effectue habituellement en mesurant une tension à l'entrée du dispositif de détection, cette tension étant prélevée sur le bus.

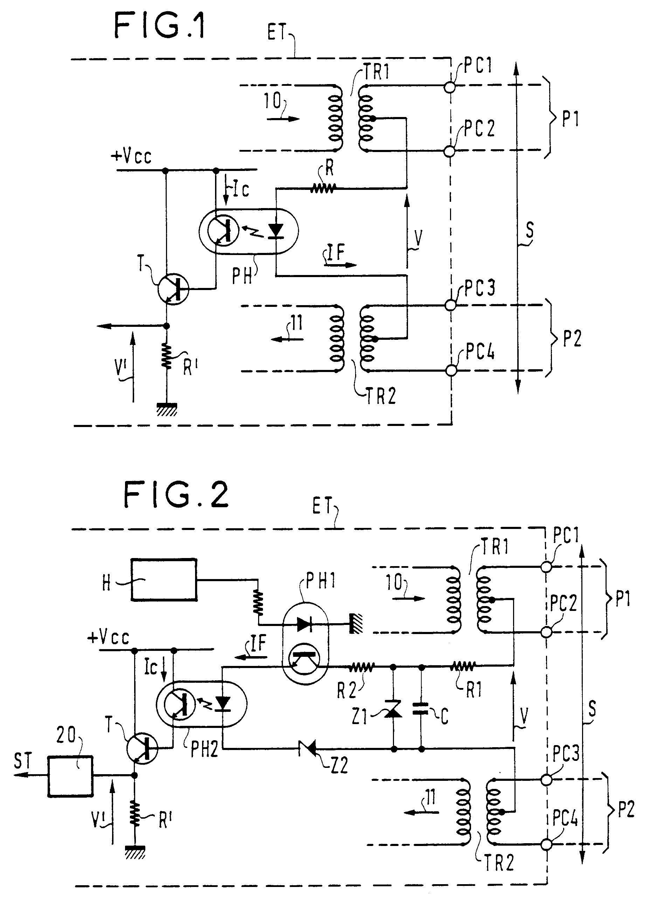

La figure 1 représente le schéma électrique d'un dispositif de détection de connexion d'un terminal d'usager à une ligne de transmission.

Dans ce mode de réalisation, la ligne de transmission comporte deux paires de conducteurs P1,P2 destinées chacune à transmettre des signaux. Le mode de transmission est donc du type full duplex. Les paires P1 et P2 constituent par exemple un bus S, c'est à dire qu'elles sont raccordées à une interface standard d'accès usager au RNIS. Les paires P1 et P2 sont connectées respectivement à des bobinages à point milieu de transformateurs TR1 et TR2, ces bobinages constituant les accès de branchement à l'interface S. La paire P1 est par exemple destinée à transmettre vers le réseau des informations en provenance d'un terminal d'usager ET, comme indiqué par la flèche 10, et la paire P2 à recevoir des informations dudit réseau pour les transmettre vers l'équipement ET, comme indiqué par la flèche 11. Les paires P1 et P2 sont chacune porteuses d'un potentiel fantôme et la différence de potentiel disponible entre les deux points milieu qui constituent les accès au circuit fantôme est notée V. Cette différence de potentiel V peut par exemple assurer une téléalimentation de certains terminaux d'usager si ceux-ci ne possèdent pas leur propre alimentation. Un terminal d'usager est connectable aux paires P1 et P2 de la ligne de transmission à l'aide d'une fiche comprenant des points de contact référencés PC1, PC2, PC3 et PC4. On appelera ci-après connexion le branchement respectif des points de contact PC1,PC2 et PC3,PC4 aux paires P1 et P2. Lorsqu'une telle connexion est réalisée, un courant IF traverse une résistance R et la photodiode d'un photocoupleur PH compris dans l'équipement ET. Le courant IE est égal à:

$$IF = (V-Vd)/R$$

où:

- Vd est la chute de tension dans la photodiode du photocoupleur PH (de l'ordre de quelques centaines de mV);
- V est compris entre 40 volts +5% et 40 volts -40%, soit entre 24 et 42 volts continus (recommandation I430 du CCITT).

Le photocoupleur PH assure une isolation galvanique entre le réseau et l'équipement ET. Selon les besoins, la valeur d'isolement requise est comprise entre 1500 et 3000 volts.

La présence du courant IF provoque l'apparition d'un courant Ic au collecteur du phototransistor constituant, avec la photodiode, le photocoupleur PH. Ce photocoupleur PH constitue un détecteur d'énergie électrique. Le courant Ic est amplifié par un transistor T coopérant avec le phototransistor pour constituer un étage de type Darlington. Cet étage est alimenté par une source de tension +Vcc interne à l'équipement ET ou obtenue à partir de la tension V servant alors de tension de téléalimentation pour le terminal concerné, ceci par l'intermédiaire de moyens assurant le respect de la clause relative à l'isolation galvanique. Le gain apporté par le montage Darlington permet d'obtenir une tension V' aux bornes d'une résistance R' reliée entre l'émetteur du transistor T et la masse de l'équipement ET. La présence de la tension V' indique à l'équipement ET qu'il est connecté au réseau de transmission. L'équipement ET peut alors initialiser certains paramètres, se mettre en état de veille, ou effectuer toute autre action nécessitée à la suite de sa connexion au réseau.

La puissance prélevée sur le réseau de transmission par le dispositif de détection est due essentiellement à la résistance R. Cette puissance est limitée, d'après la recommandation I430 du CCITT, à 3 mW, pour respecter les exigences requises de consommation lorsque les conditions d'alimentation sont restreintes. Pour une tension V maximale de 42 volts, le courant IF parcourant la résistance R et la photodiode du phototransistor PH doit donc au maximum être égal à environ 70 μA. Or, les fabricants de photocoupleurs ne garantissent le bon fonctionnement des photocoupleurs que pour des courants IF plus importants, en général à partir de 500 μA. En-deçà de cette valeur de courant, il est difficile de disposer d'une fonction de transfert Ic/IF bien définie et suffisamment stable. Le bon fonctionnement d'un détecteur de connexion suppose alors, lorsque l'on veut respecter les recommandations du CCITT, d'adapter, pour chaque modèle de photocoupleur, l'amplification assurée pour obtenir une sensibilité suffisante du détecteur de connexion. L'étage d'amplification doit alors être adapté au modèle de photocoupleur utilisé. Il en va de même du comparateur de la tension fournie par le détecteur à une tension de référence.

Il n'est donc pas possible de généraliser la structure du dispositif de détection de connexion du fait des dispersions des caractéristiques des photocoupleurs.

Cette entrave à la reproductibilité engendrée par les dispersions des caractéristiques des photocoupleurs peut être éliminée en chargeant la ligne de transmission de façon plus importante, c'est à dire en abaissant la valeur de la résistance R pour obtenir un courant IF permettant une reproductibilité du dispositif de détection de connexion. Il est cependant alors nécessaire de générer un courant IF de l'ordre de 500 μA (courant IF garantissant un bon fonctionnement du dispositif à partir de photocoupleurs du commerce actuellement disponibles), soit environ 7 fois plus important que celui autorisé par le CCITT, ce qui est inacceptable si le dispositif doit répondre aux normes de consommation précédemment décrites.

En conclusion, les détecteurs de connexion d'un terminal d'usager à une ligne de transmission du type RNIS par exemple, ne peuvent pas être réalisés tous sur le même modèle du fait des dispersions des caractéristiques des composants utilisés.

Deux solutions contraignantes et coûteuses sont alors envisageables: le tri des photocoupleurs ou s'astreindre à des réglages particuliers pour chacun des détecteurs mis en oeuvre, ceci sous peine de ne pas répondre aux exigences de consommations préconisées par le CCITT.

De façon générale, il est avantageux de requérir de tout dispositif destiné à détecter la présence ou l'absence d'une différence de potentiel qu'il ne prélève qu'une puissance réduite afin de limiter la consommation en courant du détecteur. Lorsqu'un tel dispositif met en oeuvre des composants ne fonctionnant correctement qu'à partir d'un seuil d'énergie correspondant à une puissance supérieure à celle prélevée, par exemple entre deux conducteurs électriques, il est nécessaire de tenir compte des dispersions des caractéristiques de ces composants pour adapter le dispositif à la mesure effectuée, d'où une non reproductibilité du dispositif de détection.

La présente invention a notamment pour objectif de pallier ces inconvénients.

Plus précisément, un des objectifs de l'invention est de fournir un dispositif d'évaluation de la tension fournie par une source de tension, cette évaluation consistant à détecter si une différence de potentiel est ou non disponible entre deux conducteurs électriques constituant une source de tension, ce dispositif permettant de prélever un courant minime de cette source et une reproduction de sa fabrication pour des composants mis en oeuvre présentant des dispersions de caractéristiques importantes.

Un autre objectif de l'invention est de fournir un tel dispositif d'évaluation appliqué à la détection de connexion d'un équipement à une ligne de transmission obéissant aux recommandations de consommation du CCITT, et notamment à la recommandation I430 concernant spécifiquement les réseaux de transmission appliqués au RNIS.

Un autre objectif de l'invention est de fournir un tel dispositif de détection de connexion d'un équipement à une ligne de transmission où un photocoupleur est utilisé en temps que moyen de détection d'énergie électrique, des dispersions de caractéristiques importantes pouvant être observées d'un photocoupleur à un autre.

Ces objectifs, ainsi que d'autres qui apparaîtront par la suite, sont atteints grâce à un dispositif d'évaluation de la tension fournie par une source de tension, ce dispositif comportant:

- des premiers moyens pour prélever de l'énergie de la source de tension et pour stocker l'énergie prélevée dans des moyens de stockage;

- des seconds moyens pour décharger sur commande l'énergie stockée par les moyens de stockage dans des moyens de détection d'énergie électrique indiquant la valeur de la tension fournie par la source de tension avec une puissance au moins égale à la puissance minimale requise par les moyens de détection d'énergie électrique, cette puissance minimale requise étant supérieure à la puissance de prélèvement de l'énergie de la source de tension par les premiers moyens.

La détection d'une différence de potentiel s'effectue donc en deux temps. Un premier intervalle de temps est utilisé pour prélever et stocker de l'énergie sans dépasser un certain seuil de puissance et un second intervalle de temps est utilisé pour transférer cette énergie accumulée vers des moyens de détection avec une puissance suffisante pour permettre le fonctionnement de ces moyens de détection.

Avantageusement, la tension est prélevée sur un bus de transmission de signaux constitué de deux paires de conducteurs constituant une liaison full duplex et le dispositif est utilisé pour détecter la connexion d'un équipement, dans lequel il est compris, au bus de transmission.

Dans cette application, le dispositif de détection de la présence ou de l'absence d'une tension est donc utilisé pour détecter la connexion ou l'absence de connexion d'un équipement à un bus de transmission.

Selon un mode de réalisation particulier, le bus de transmission constitue l'interface S d'un réseau de transmission de type RNIS et l'équipement est constitué par un terminal d'usager ou par un adaptateur de terminal au réseau.

Préférentiellement, les moyens de détection d'énergie électrique sont constitués par un photocoupleur et les moyens de stockage par un condensateur.

On assure ainsi une isolation galvanique du dispositif par rapport au bus de transmission et l'énergie emmagasinée correspond à une différence de potentiel.

Le dispositif de l'invention comporte avantageusement des moyens empêchant l'activation des moyens de détection d'énergie électrique par la puissance minimale requise lorsque la tension est inférieure à une valeur de seuil déterminée.

On ne détecte ainsi pas de différence de potentiel si celle-ci est inférieure à une valeur donnée. Ceci permet de ne pas considérer qu'un équipement a été connecté à une ligne de transmission si la tension permettant de détecter la connexion est inférieure à un seuil donné, signifiant une anomalie.

Préférentiellement, les seconds moyens pour transférer l'énergie stockée dans les moyens de stockage vers les moyens de détection de la présence de la tension sont constitués par un photocoupleur comprenant un phototransistor dont la conduction est commandée par un signal généré par une horloge.

L'utilisation d'un photocoupleur permet d'assurer une isolation galvanique entre la commande de transfert d'énergie, en l'occurrence l'horloge, et la source de tension.

Avantageusement, le signal généré par cette horloge est un signal périodique.

L'énergie contenue dans les moyens de stockage est donc cycliquement transférée vers les moyens de détection, quelle que soit sa valeur. La détection de connexion (ou de déconnexion) de l'équipement à (de) la ligne de transmission s'opère ainsi en un temps au maximum égal à la période de l'horloge.

Préférentiellement, les moyens de détection d'énergie électrique fournissent une impulsion à un circuit monostable dont la période d'activation est supérieure à la période du signal généré par cette horloge.

Un tel circuit monostable assure donc la mise en forme du signal fourni par les moyens de détection d'énergie électrique et permet d'indiquer par un état logique si la différence de potentiel est ou non disponible à l'entrée du dispositif d'évaluation de tension de l'invention.

D'autres caractéristiques et avantages de l'invention apparaîtront à la lecture de la description suivante d'un mode de réalisation préférentiel de l'invention, donné à titre illustratif et non limitatif, et des dessins annexés dans lesquels:

- la figure 1 représente, comme il vient d'être décrit, le schéma électrique d'un détecteur de connexion d'un terminal d'usager à une ligne de transmission, selon un mode de réalisation connu ;

- la figure 2 représente le schéma électrique d'un détecteur de connexion d'un terminal d'usager à une ligne de transmission, selon un mode de réalisation préférentiel de l'invention ;

- la figure 3 représente des chronogrammes corrélatifs simplifiés de signaux prélevés en différents points du dispositif de la figure 2.

Dans l'exemple de réalisation de la figure 2, la ligne de transmission est également constituée de deux paires de conducteurs P1 et P2, P1 étant par exemple une paire servant à l'émission de signaux et P2 une paire servant à la réception de signaux. La paire P1 fournit un potentiel positif par rapport à un potentiel de référence véhiculé sur la paire P2 et une tension continue V est constamment disponible entre les points milieu des enroulements considérés des transformateurs TR1 et TR2 raccordés aux extrémités des paires P1 et P2. La connexion de l'équipement ET au réseau de transmission par l'intermédiaire des points PC1, PC2 et PC3, PC4 regroupés dans une fiche, comme vu précédemment, provoque l'apparition d'un courant de charge d'un condensateur C à travers une résistance R1. La résistance R1 et le condensateur C constituent des moyens pour prélever de l'énergie de la source de tension et forment un intégrateur, branché entre les points milieu de TR1 et TR2, de constante de temps $\tau$. La résistance R1 est calculée de telle sorte que la puissance maximale prélevée sur la ligne de transmission ne dépasse pas 3 mW. On a donc la relation:

$$3 \text{ mW} = V^2/R1 = (42 \text{ volts max})^2/R1$$
$$\text{d'où } R1 \text{ max} = 588 \text{ k}\Omega$$

On respecte ainsi la recommandation I430 du CCITT en ne consommant qu'un courant très faible, de l'ordre de 70 µA.

Le condensateur C constituant un moyen de stockage de l'énergie prélevée se charge, au cours des temps bas d'un signal issu d'une horloge H, jusqu'à une valeur de tension au maximum égale à la tension V. Après un certain temps, qui ne peut excéder un temps bas du signal d'horloge, suivant la connexion de l'équipement ET au réseau S, le condensateur C est considéré comme chargé. Des moyens de décharge du condensateur C peuvent alors être activés. Ces moyens de décharge sont constitués par un photocoupleur PH1 commandé par l'horloge H délivrant des impulsions de commande du courant circulant dans la photodiode du photocoupleur PH1 à travers une résistance non référencée. Chaque impulsion positive de l'horloge H provoque la conduction du phototransistor du photocoupleur PH1 et l'énergie accumulée dans le condensateur C est transférée vers la diode d'un photocoupleur PH2 à travers une résistance R2 placée en amont du phototransistor du photocoupleur PH1. L'horloge H, la résistance non référencée et le photocoupleur PH1 constituent ainsi un interrupteur commandé garantissant une isolation galvanique élevée, requise dans ce type d'application.

Une diode zéner Z1, dont la tension de seuil est avantageusement choisie supérieure à la tension V, est connectée en parallèle sur le condensateur C. Cette diode zéner n'est pas indispensable au fonctionnement du dispositif. Elle garantit néanmoins une protection de ce condensateur C et des autres composants en parallèle sur celui-ci, contre d'éventuelles surtensions provenant du réseau. Elle permet également d'éviter que d'éventuelles surtensions provenant du dispositif de détection ne perturbent le fonctionnement du bus de transmission.

Le courant IF traversant la photodiode du photocoupleur PH2 est très supérieur au courant maximal de charge (pic de courant apparaissant au début de la charge du condensateur C) du condensateur C dès lors que R2 est très inférieur à R1. Le courant IF est égal à:

$$IF = (Vc-Vce-Vd-VZ2)/R2$$

où:
- Vc est la tension aux bornes du condensateur C;
- Vce est la chute de tension dans la jonction émetteur-collecteur du phototransistor du photocoupleur PH1;
- Vd est la chute de tension dans la photodiode du photocoupleur PH2;

- VZ2 est la chute de tension due à la présence d'une diode zéner Z2 en série dans le circuit de détection. La valeur de stabilisation de Z2 est bien entendu inférieure à celle de Z1. La raison de la présence de cette diode zéner Z2 sera expliquée par la suite.

Le courant IF est indépendant de la valeur de R1 lorsque R1 est très supérieur à R2. Il est ainsi possible d'obtenir aisément un courant impulsionnel IF suffisant pour permettre sa détection par le phototransistor du photocoupleur PH2. Ce courant IF permet d'assurer un fonctionnement stable du photocoupleur PH2 dans la limite des caractéristiques garanties par son constructeur. Les fonctions de transfert Ic/IF dont on dispose, de photocoupleurs différents, ont ici une valeur bien définie et suffisamment stable quel que soit le photocoupleur utilisé, d'où un fonctionnement garanti. On assure ainsi une décharge sur commande de l'énergie stockée dans le condensateur C dans le photocoupleur PH2 avec une puissance au moins égale à la puissance minimale requise par ce photocoupleur PH2, cette puissance minimale requise étant supérieure à la puissance de prélèvement de l'énergie de la source de tension par la résistance R1 et le condensateur C.

Pendant les périodes basses de l'horloge H, le condensateur C est isolé du photocoupleur PH2 et se recharge à travers R1 si la tension V est toujours présente. Ainsi, le phototransistor du photocoupleur PH2 est rendu passant à chaque période haute de l'horloge H.

Lorsqu'une connexion aux paires P1 et P2 de la ligne de transmission par l'intermédiaire des points PC1, PC2 et PC3, PC4 est établie, il apparaît des impulsions de tension aux bornes de la résistance R' branchée à la sortie de l'étage Darlington similaire à celui de la figure 1. Ces impulsions sont appliquées à un circuit de mise en forme constitué par exemple par un monostable 20 dont l'état d'activation déclenché par l'apparition d'une impulsion à son entrée est de durée plus importante que la période de l'horloge H. Le monostable 20 fournit donc un niveau logique, par exemple haut, aussi longtemps que l'équipement ET est connecté à la ligne de transmission. Il est bien entendu possible de prévoir un circuit de mise en forme différent.

Suivant le modèle de photocoupleur PH2 utilisé, le transistor T peut être optionnel.

La diode zéner Z2, facultative dans ce mode de réalisation, a pour fonction d'établir un seuil de tension à partir duquel le dispositif détecteur de connexion ne doit plus fonctionner. En effet, si la tension V passe en dessous d'une certaine valeur préalablement définie, c'est que la ligne de transmission ne comporte plus à ses bornes une tension suffisante et un terminal raccordé à la ligne ne doit alors plus détecter sa connexion au réseau. Une anomalie sur le réseau peut notamment être à l'origine d'une tension V inférieure à un certain seuil (24 volts dans l'application RNIS). Dans ce cas, la tension aux bornes de Z2 est inférieure à la tension VZ2 nécessaire à la conduction de cette diode zéner et le circuit est bloqué.

Un des avantages de l'invention est que la puissance consommée par le dispositif sur la ligne de transmission n'est que de 3 mW pendant un temps relativement bref, puisque l'énergie consommée diminue avec la charge du condensateur C. L'énergie moyenne consommée est donc inférieure à celle autorisée par le CCITT. Il est bien entendu possible de limiter encore plus cette puissance consommée en augmentant la valeur de la résistance R1 et en espaçant les instants de décharge du condensateur C, au détriment cependant de la vitesse moyenne de détection de connexion (ou de déconnexion).

L'horloge H fournit préférentiellement un signal périodique mais tout autre moyen de commande de décharge des moyens de stockage d'énergie est envisageable. Il peut par exemple s'agir de l'activation manuelle d'une touche après connexion et un dispositif bistable peut mémoriser l'état de présence de la tension à détecter jusqu'à ce que cet état se modifie.

Bien entendu, il est également possible de prélever de l'énergie de la source de tension pour stocker une certaine quantité d'énergie dans une inductance. On ne stocke alors plus une tension mais un courant et l'ouverture d'un interrupteur situé en amont de l'inductance, c'est à dire par exemple entre le point milieu du transformateur TR1 et cette inductance, provoquerait le transfert de l'énergie accumulée vers les moyens de détection constitués par le photocoupleur PH2. Ce mode de réalisation constitue une variante de celui décrit en référence à la figure 2.

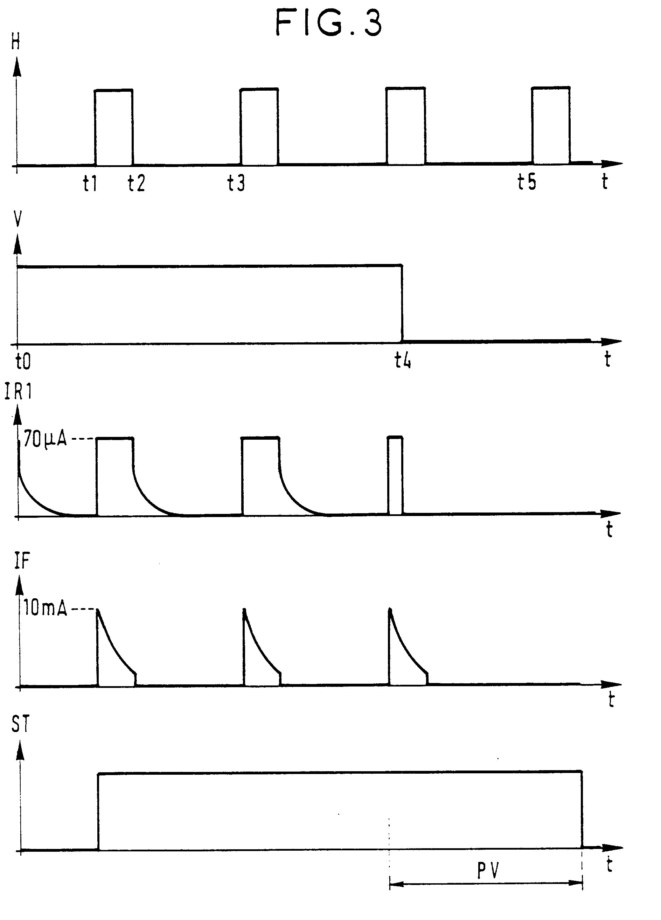

Le fonctionnement du dispositif de la figure 2 sera mieux compris à la lecture de la description suivante de la figure 3 qui représente des chronogrammes corrélatifs de signaux prélevés en différents points du dispositif de la figure 2. On comprendra qu'étant donnée la différence de valeur de courant entre IR1 et IF, les échelles en ordonnée sont différentes sur ces chronogrammes. En outre, la forme des signaux, et notamment celle des courants de charge et de décharge du condensateur C, a été simplifiée dans le but de mieux faire comprendre le fonctionnement du dispositif.

La connexion du dispositif de détection de l'invention à la ligne de transmission s'effectue à un temps t0. Il peut également s'agir de l'apparition d'une différence de potentiel entre les deux conducteurs électriques, reliés aux points milieu de TR1 et TR2, qui constituent l'entrée du dispositif de détection, comme il sera expliqué par la suite. Un courant IR1 traverse alors la résistance R1 pour charger le condensateur C à une tension inférieure ou égale à V. Un pic de courant est obtenu en début de charge puisque le condensateur C aura préalablement été déchargé. Cette charge s'effectue avec la constante de temps $\tau$ ($\tau$ = R1.C). Le courant d'appel maximum, c'est à dire au début de la charge du condensateur C, est fixé par R1 et a une valeur proche de 70 $\mu$A. Au temps t1, l'horloge H délivre une impulsion provoquant la conduction du phototransistor du photocoupleur PH1. Le condensateur C se décharge alors brutalement à travers R2 pour provoquer un courant IF dont la valeur maximale dépend essentiellement de R2 et est par exemple de l!ordre de 10 mA. Le temps d'établissement de ce courant IF est très bref du fait de la constante de temps R2.C très inférieure à $\tau$. Le courant IF traverse alors la photodiode du photocoupleur PH2 et le circuit de mise en forme constitué par le monostable 20 fournit un état logique haut sur sa sortie ST. Au temps t2, un front d'horloge descendant provoque le blocage du phototransistor du photocoupleur PH1 et permet au condensateur C de se recharger à travers R1. Le temps bas du signal d'horloge est suffisant pour permettre une recharge complète du condensateur C, c'est à dire que la durée du temps bas du signal d'horloge est préférentiellement de l'ordre de 5$\tau$. Le monostable 20 présente une période de validation PV de durée supérieure à la période de l'horloge H, afin de maintenir un niveau logique haut sur sa sortie aussi longtemps que le détecteur de présence de tension détecte effectivement la tension V. Au temps t3, une nouvelle impulsion d'horloge décharge le condensateur C et prolonge la durée de validation du monostable 20. Au temps t4, la tension V devient nulle, par exemple après déconnexion du dispositif de la ligne de transmission. Comme le condensateur C aura auparavant été chargé, une nouvelle impulsion prolonge la période de validation du monostable 20. Le condensateur C ne peut alors cependant plus être rechargé et l'apparition d'une impulsion d'horloge à un temps t5 ne provoque donc plus l'apparition du courant IF. Le monostable 20 retombe alors à la fin de sa période de validation PV.

Le dispositif de l'invention permet donc d'évaluer la tension fournie par une source de tension. Cette évaluation revient à indiquer la présence ou l'absence de cette tension. Dans l'application décrite, il permet de détecter la connexion de l'équipement dans lequel il est compris à une ligne de transmission porteuse d'une tension caractéristique, par exemple une tension de téléalimentation.

Lorsque le terminal d'usager est constitué par un poste téléphonique adapté au RNIS, les tensions d'alimentation des différents éléments du détecteur peuvent être obtenues à partir de cette tension V à détecter. En revanche, dans le cas où l'équipement est constitué par un adaptateur de terminal au réseau, celui-ci possède généralement sa propre alimentation et la tension V ne sert qu'à la détection de connexion.

Le dispositif de l'invention permet donc de détecter la connexion d'un terminal d'usager à une ligne de transmission. Il s'applique préférentiellement lorsque la puissance disponible est limitée, situation fréquente lorsque plusieurs terminaux (huit dans le cas du RNIS) doivent pouvoir être connectés à la même ligne.

Bien entendu, la présente invention n'est pas limitée à l'application de détection de connexion de terminaux d'usager à une ligne de transmission. Le dispositif s'applique dès qu'une tension est à détecter entre deux conducteurs et préférentiellement lorsque des critères de consommation, c'est à dire de puissance prélevée par le dispositif de détection, prennent une certaine importance. Le dispositif peut également être constamment connecté aux bornes de deux conducteurs et signaler l'apparition d'une différence de potentiel entre ces conducteurs lorsqu'une telle différence de potentiel leur est appliquée.

Lorsqu'il n'est pas nécessaire d'isoler galvaniquement le dispositif de détection de différence de potentiel par rapport aux conducteurs électriques présentant cette différence de potentiel, les photocoupleurs PH1 et PH2 peuvent être remplacés par des dispositifs moins coûteux, par exemple par des transistors. Dans cette application, il n'y a plus d'isolation galvanique et le courant nécessité pour commander la conduction (par exemple le courant de base d'un transistor commandant sa conduction) doit être plus important.

**Revendications**

1. Dispositif d'évaluation de la tension fournie par une source de tension, caractérisé en ce qu'il comporte:
   - des premiers moyens (R1,C) pour prélever de l'énergie de ladite source de tension et pour stocker l'énergie prélevée dans des moyens (C) de stockage;
   - des seconds moyens (PH1) pour décharger sur commande ladite énergie stockée par lesdits moyens (C) de stockage dans des moyens (PH2) de détection d'énergie électrique indiquant la valeur de la tension fournie par ladite source de tension avec une puissance au moins égale à la puissance minimale requise par lesdits moyens (PH2) de détection d'énergie électrique, cette puissance minimale requise étant supérieure à la puissance de prélèvement de l'énergie de ladite source de tension par lesdits premiers moyens (R1,C).

2. Dispositif selon la revendication 1, caractérisé en ce que ladite tension (V) est prélevée sur un bus de transmission de signaux constitué de deux paires de conducteurs (P1,P2) constituant une liaison full duplex, et en ce que ledit dispositif est utilisé pour détecter la connexion d'un équipement (ET), dans lequel il est compris, audit bus de transmission.

3. Dispositif selon l'une des revendications 1 et 2, caractérisé en ce que ledit bus de transmission constitue l'interface S d'un réseau de type RNIS, et en ce que ledit équipement (ET) est constitué par un terminal d'usager ou par un adaptateur de terminal audit réseau.

4. Dispositif selon l'une des revendications 1 à 3, caractérisé en ce que lesdits moyens de détection d'énergie électrique sont constitués par un photocoupleur (PH2).

5. Dispositif selon l'une des revendications 1 à 4, caractérisé en ce que lesdits moyens de stockage sont constitués par un condensateur (C).

6. Dispositif selon l'une des revendications 1 à 5, caractérisé en ce qu'il comporte des moyens (Z2) empêchant l'activation desdits moyens (PH2) de détection d'énergie électrique par ladite puissance minimale requise lorsque ladite tension (V) fournie par ladite source de tension est inférieure à une valeur de seuil déterminée.

7. Dispositif selon l'une des revendications 1 à 6, caractérisé en ce que lesdits seconds moyens (PH1) pour transférer ladite énergie stockée par lesdits moyens (C) de stockage dans lesdits moyens (PH2) de détection d'énergie électrique sont constitués par un photocoupleur (PH1) comprenant un phototransistor dont la conduction est commandée par un signal généré par une horloge (H).

8. Dispositif selon la revendication 7, caractérisé en ce que ledit signal généré par ladite horloge (H) est un signal périodique.

9. Dispositif selon l'une des revendications 1 à 8, caractérisé en ce que lesdits moyens (PH2) de détection d'énergie électrique fournissent une impulsion à un circuit monostable (20) dont la période d'activation est supérieure à la période dudit signal généré par ladite horloge (H).

# FIG.1

# FIG.2

8

# FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | PATENT ABSTRACTS OF JAPAN vol. 6, no. 9 (E-90)(887) 20 Janvier 1982 & JP-A-56 132 813 ( MITSUBISHI ) 17 Octobre 1981 * abrégé * | 1 | G01R19/165 |
| A | GB-A-2 164 162 (STC PLC) * abrégé; figure * | 1 | |
| A | GB-A-2 056 093 (STANDARD TELEPHONES AND CABLES) * abrégé; revendication 1; figure 1 * | 1 | |
| A | WO-A-8 802 121 (ADVANCED MICRO DEVICES) * page 13, ligne 17 - ligne 22; figure 1 * | 1 | |
| A | US-A-4 658 198 (THURBER) * colonne 4, ligne 21 - ligne 28; figure 2 * | 1 | |

-----

**DOMAINES TECHNIQUES RECHERCHES (Int. Cl.5 )**

H04Q
G01R
H04M
G11C

Le présent rapport a été établi pour toutes les revendications

| Lieu de la recherche | Date d'achèvement de la recherche | Examinateur |
|---|---|---|
| BERLIN | 01 AVRIL 1993 | KEMPEN P. |